(19) Europäisches Patentamt
European Patent Office
Office européen des brevets

(11) **EP 1 115 915 B1**

(12) **EUROPÄISCHE PATENTSCHRIFT**

(45) Veröffentlichungstag und Bekanntmachung des Hinweises auf die Patenterteilung:
**13.07.2005 Patentblatt 2005/28**

(21) Anmeldenummer: **99947211.1**

(22) Anmeldetag: **13.07.1999**

(51) Int Cl.$^7$: **C25D 17/00**, H05K 3/24, C25D 17/06

(86) Internationale Anmeldenummer:
**PCT/DE1999/002187**

(87) Internationale Veröffentlichungsnummer:
**WO 2000/011679 (02.03.2000 Gazette 2000/09)**

(54) **ELEKTROCHEMISCHE BEHANDLUNGSANLAGE UND VERFAHREN ZUR ZUFÜHRUNG VON STROM ZU ELEKTROLYTISCH BEHANDELNDEM LEITERPLATTENMATERIAL**

ELECTROCHEMICAL TREATMENT ASSEMBLY AND PROCESS OF FEEDING CURRENT TO A PRINTED BOARD MATERIAL

APPAREIL DE TRAITEMENT ELECTROCHIMIQUE ET PROCEDE POUR FOURNIR DU COURANT AU CIRCUIT IMPRIME A TRAITER ELECTROLYTIQUEMENT

(84) Benannte Vertragsstaaten:
**AT BE CH CY DE DK ES FI FR GB GR IE IT LI LU MC NL PT SE**

(30) Priorität: **19.08.1998 WOPCT/DE98/02503**

(43) Veröffentlichungstag der Anmeldung:
**18.07.2001 Patentblatt 2001/29**

(73) Patentinhaber: **Atotech Deutschland GmbH 10553 Berlin (DE)**

(72) Erfinder: **LANGHEINRICH, Peter D-90537 Feucht (DE)**

(74) Vertreter: **Effert, Bressel und Kollegen Radickestrasse 48 12489 Berlin (DE)**

(56) Entgegenhaltungen:
**WO-A-97/46740          WO-A-99/29931**

**Beschreibung**

Die Erfindung betrifft eine elektrochemische Behandlungsanlage für elektrolytisch zu behandelndes Leiterplattenmaterial, die mindestens ein Kontaktierungsorgan für die Stromzuführung zu dem Leiterplattenmaterial aufweist sowie ein Verfahren zur Zuführung von Strom zu dem Leiterplattenmaterial.

Zur elektrolytischen Behandlung von Gegenständen müssen diese transportiert und elektrisch kontaktiert werden, um Strom zuzuführen, während sie mit einer Behandlungsflüssigkeit in Kontakt stehen.

Hierzu werden unterschiedliche Einrichtungen eingesetzt. Beispielsweise ist in US-A-4.767.146 eine Haltezange für Leiterplatten beschrieben, die zwei Schenkel mit jeweils zwei Greifarmen aufweist. Die Schenkel mit den Greifarmen sind durch Federkraft um eine obere Achse verschwenkbar, so daß die unteren Enden zusammengedrückt werden. An den unteren Enden sind die Greifarme zahnartig ausgebildet. An den Armen des einen Schenkels sind jeweils zwei zahnartige Vorsprünge und an den Armen des andern Schenkels jeweils ein zahnartiger Vorsprung vorgesehen.

Diese Kontaktier- und Halteeinrichtung wird in herkömmlichen elektrolytischen Tankanlagen eingesetzt, bei denen die Leiterplatten in vertikaler Ausrichtung gehalten und in die Tauchbäder eingesenkt werden.

Eine andere Verfahrensweise besteht darin, die Gegenstände in horizontaler Richtung durch die einzelnen Behandlungsstationen hindurchzuführen.

In DE 25 12 762 B2 werden Stromkontaktfedern zur Kontaktierung von zu verchromenden Gegenständen vorgeschlagen, die an Werkstückhaltern befestigt sind. Die Gegenstände werden hierzu in die aus zwei federnden Bügeln gebildeten Kontaktfedern eingespannt.

Auch für die elektrolytische Behandlung von plattenförmigen Gegenständen, insbesondere Leiterplatten, werden seit einiger Zeit Beschichtungsanlagen eingesetzt, durch die die Platten in horizontaler Richtung transportiert werden. Hierzu werden die Platten mit der Behandlungsflüssigkeit, beispielsweise einem Galvanisierungsbad oder einer für das elektrolytische Ätzen geeigneten Flüssigkeit, in Kontakt gebracht. Um Strom zu den Platten zuführen zu können, werden geeignete Kontaktelemente vorgesehen. Außerdem werden die Platten mit Transportorganen durch die Anlage hindurch geführt.

In WO 97/37062 A1 ist ferner eine Vorrichtung zum elektrochemischen Behandeln von elektrisch leitfähigen und gegeneinander isolierten Bereichen auf Leiterplatten beschrieben. Zur elektrischen Kontaktierung der Bereiche werden Bürsten verwendet, mit deren dünnen, elektrisch leitfähigen Fasern die zu behandelnden struktunerten Oberflächen kontaktiert werden. Die Leiterplatten werden in horizontaler Richtung und in horizontaler Ausrichtung an den feststehenden Bürsten vorbeigeführt, so daß die Bürstenspitzen über die Oberflächen hinweg streichen. Diese Vorrichtung ist nicht zur Übertragung großer Ströme auf die Leiterplatten geeignet. Für den praktischen Einsatz ist es außerdem schwierig, eine Lösung zu finden, bei der die Bürsten einerseits eine ausreichende Lebensdauer aufweisen und die Leiterplattenoberflächen andererseits nicht beschädigt werden.

Aus DE 36 45 319 C2 ist eine Anordnung zum elektrolytischen Behandeln von plattenförmigen Gegenständen, wie Leiterplatten, bekannt. Die Leiterplatten werden in dieser Anordnung in horizontaler Richtung und horizontaler Ausrichtung geführt und dabei von Klammern gehalten, die als Transport- und Kontaktierungsorgane verwendet werden. Die Klammern bestehen jeweils aus zwei Bügeln, die durch Federdruck um ihren gegenseitigen und Strom leitenden Verbindungs- bzw. Anlegepunkt so verschwenkt werden, daß ihre unteren Enden gegeneinandergepreßt werden und dabei den Seitenrand (Galvanorand) der Leiterplatten erfassen. Die Randbreite beträgt in der Praxis 10 bis 15 mm. Jede Leiterplatte wird typischerweise auf mindestens einer Seite über mehrere Klammern kontaktiert.

In WO 97/46740 A1 ist eine Halteklammer für in einem Bad zu metallisierende Gegenstände offenbart, die aus zwei Schenkeln besteht, zwischen denen der Gegenstand festgeklemmt werden kann. An den Klemmpunkten befinden sich an beiden Schenkeln Kontaktbolzen. Die Bolzen sind an den Seitenflächen mit Dichtringen gegen die Elektrolytlösung isoliert. In einer Ausführungsform sind, zwei, drei, vier oder mehr derartige Bolzen an jedem der Schenkel vorgesehen.

Um die elektrolytische Behandlung von Leiterplatten zu beschleunigen, wird der Stromfluß in der Praxis in diesen Anlagen zunehmend erhöht. Typische Werte für den Stromfluß liegen bei gängigen Leiterplatten heute bereits bei beispielsweise 20 bis 80 A pro Leiterplattenseite und pro Klammerkontakt, wenn der Abstand zwischen den Klammern beispielsweise 60 mm beträgt. Die einer gesamten Leiterplattenseite mittels mehrerer Klammern zugeführten Ströme sind wesentlich höher.

Werden beide Seiten erfassende und elektrischen Kontakt vermittelnde Klammern für die elektrolytische Behandlung von doppelseitig kupferkaschierten Leiterplatten verwendet, führt eine Klammer damit 40 bis 160 A. Derart große Ströme können nur noch mit Schwierigkeiten auf die dünne Basisleitschicht der Platten übertragen werden. Bei großen Strömen verarmen die Metallionen in der Elektrolytlösung in der Nähe der Kontakte, so daß die abgeschiedene Metallschicht in der Umgebung der Kontaktierungsstellen auf den Leiterplatten anbrennen (= Bildung grobkristalliner Metallschichten).

Es wurde auch beobachtet, daß die dargestellten Phänomene verstärkt dann auftreten, wenn eine Kupferbasisschicht mit geringer Schichtdicke elektrolytisch metallisiert wird. Aus verschiedenen Gründen ist eine Reduzierung der Schichtdicke von bisher 17 µm auf derzeit 6 µm und weiterhin auf beispielsweise 0,7 µm (bei Anwendung bestimmter Fertigungstechniken [SBU-Technik = Sequential-Build-Up]) notwendig, beispielsweise wenn feine Bohrungen (100 µm und kleiner) mit Laserlicht gebohrt werden müssen oder um eine Unterätzung wie bei der Anwendung dickerer Kupferbasisschichten zu vermeiden, ferner auch aus Materialersparnisgründen und zur Optimierung der elektrischen Eigenschaften der Platten.

Mit den bekannten Einrichtungen sind diese steigenden Anforderungen in der modernen Leiterplattenfertigung nicht mehr zu erfüllen. Es hat sich herausgestellt, daß die Basiskupferschichten an den Kontaktierungsstellen und in den angrenzenden Bereichen dieser Stellen auf den Leiterplattenoberflächen "verbrennen". Das bedeutet, daß sich an diesen Stellen großräumig schwarze Stellen bilden, an denen die Kupferschicht beschädigt und teilweise sogar vollständig zerstört ist. Diese Beschädigungen oder Zerstörungen sind zwar teilweise auf die Bereiche begrenzt, in denen keine Leiterbahnstrukturen auf dem Leiterplattenmaterial gebildet werden sollen. Häufig sind diese beschädigten Stellen aber so groß, daß die Randbereiche der Leiterbahnstruktur ebenfalls beschädigt werden. In diesem Fall führt dies zwangsläufig zum Ausschuß der bearbeiteten Platte. Besonders störend an den Verbrennungsstellen wirkt der teilweise lose auf der Platte liegende Abbrand (feines oxidiertes Kupfer), der mit der Elektrolytströmung auf der Plattenoberfläche verteilt und dort bei der Metallabscheidung in die Schicht eingebaut wird. Dies führt dazu, daß die Platte unbrauchbar wird.

Da aus Kostengründen immer geringere Galvanorandbreiten gewünscht werden, gleichzeitig die Behandlungsstromdichte erhöht und die Dicke der Kupferbasisschicht erniedrigt werden sollen, ergeben sich die vorgenannten Probleme. ,

Der Erfindung liegt von daher das Problem zugrunde, die Nachteile der bekannten Vorrichtungen und Verfahren zu vermeiden und insbesondere Mittel zu finden, um bei sehr großem Behandlungsstrom eine zufriedenstellende elektrolytische Behandlung zu erreichen, wobei gleichzeitig auch mögliche Beeinträchtigungen der Metallschicht auf der Plattenoberfläche nur in einem sehr schmalen Randbereich tolerierbar sind und die vorgenannten Anforderungen auch bei Verwendung sehr dünner Kupferschichten auf den Platten erfüllt werden können.

Die vorstehend angegebenen Probleme werden gelöst durch die erfindungsgemäße elektrochemische Behandlungsanlage mit mindestens einem Kontaktierungsorgan das jeweils mindestens ein Kontaktelement aufweist nach Anspruch 1 und das Verfahren zur Zuführung von Strom nach Anspruch 6.

Das Kontaktelement dient zur Stromzuführung zu elektrolytisch zu behandelnden Leiterplatten in sogenannten Horizontalanlagen, in denen die Leiterplatten in horizontaler Richtung transportiert und entweder im wesentlichen horizontal oder im wesentlichen vertikal ausgerichtet sind. Als elektrolytische Behandlung kommen die elektrolytische Metallabscheidung und das elektrolytische Ätzen sowie andere elektrolytische Behandlungsarten, beispielsweise das elektrolytische Reinigen, in Betracht.

Das Kontaktelement weist eine oder mehrere Kontaktflächen auf, wobei die Form der Kontaktflächen derart ausgebildet ist, daß bei der Übertragung von großen Strömen von dem auf Kontaktierungsflächen auf einer elektrisch leitfähigen Oberfläche aufgedrückten Kontaktelement auf die Kupferoberfläche in den an die Kontaktierungsflächen angrenzenden Bereichen der Oberfläche keine Beschädigungen auftreten. Die großen Ströme können sowohl auf Kupferoberflächen von Leiterplattenmaterialien als auch auf Oberflächen aus Zinn-, Zinn/Blei-Legierung oder einem anderen elektrisch leitfähigen Material übertragen werden.

Das Kontaktierungsorgan weist mindestens einen Schaft und mindestens ein Kontaktelement auf. Das Kontaktelement ist an einem Ende des Schaftes angeordnet. Das Schaftende kann gegenüber dem Schaft beispielsweise um etwa 90° abgebogen sein. Der Schaft kann auch gerade ausgerichtet sein. Der Schaft ist mit dem Kontaktelement über eine Rückstellkraft derart bewegbar, daß es auf die Oberfläche des Leiterplattenmaterials gedrückt werden kann. In einer bevorzugten Ausführungsform besteht das Kontaktierungsorgan aus zwei derartigen Schäften, die an ihrem unteren Ende jeweils um etwa 90° abgebogen sind. An den abgebogenen Enden ist jeweils ein Kontaktelement befestigt. Die beiden Schäfte sind so gegeneinander verschiebbar, daß die einander gegenüberliegenden Kontaktelemente zueinander oder voneinander weg bewegt werden können. Die beiden vorzugsweise ebenen Kontaktflächen sind deckungsgleich zueinander angeordnet, wenn die Klammer geschlossen ist. Die Flächen werden vorzugsweise mittels Federkraft aufeinandergedrückt.

Das erfindungsgemäße Verfahren dient zur Zuführung von Strom zu dem Leiterplattenmaterial, wobei mindestens ein stromführendes Kontaktelement auf die Oberflächen des Leiterplattenmaterials aufgedrückt und dadurch ein Stromfluß zwischen den Kontaktelementen und dem Leiterplattenmaterial erzeugt wird.

Mit dem Kontaktelement ist es nunmehr problemlos möglich, auch große Ströme von beispielsweise 40 bis 160 A mit einem einzelnen Kontaktierungsorgan, das mindestens ein derartiges Kontaktelement aufweist, auf die Leiterplatten zu übertragen. Im Gegensatz zu den Verfahren, bei denen die herkömmlichen Kontaktelemente eingesetzt werden, werden die Kupferoberflächenbereiche, die an die Kontaktierungsstellen auf den Oberflächen der zu behandelnden Gegenstände angrenzen, auch bei Anwendung sehr großer Ströme nicht beschädigt. So kann ein Strom von zum Beispiel 60 A und selbstverständlich auch ein Strom von weniger als 60 A über das hier beschriebene Kontaktelement auf die Kupferoberflächen eines mit einer beispielsweise 6 μm dicken Kupferkaschierung versehenen Leiterplattenmaterials übertragen werden, ohne daß die an die Kontaktierungsstellen angrenzenden Oberflächenbereiche merklich beschädigt, beispielsweise unter Bildung eines schwarzen Grieses abgetragen werden. Werden noch dünnere Kupferschichten auf dem Leiterplattenmaterial eingesetzt, beispielsweise eine 0,7 μm dicke Schicht, können die erwähnten Probleme beim Einsatz der bekannten Vorrichtungen bereits bei wesentlich geringeren Strömen auftreten. Mit den Kontaktelementen gemäß der vorliegenden Erfindung ist die beschriebene Schädigung bei diesen Materialien auch bei einem Stromfluß von beispielsweise 40 A nicht beobachtbar.

Durch nähere Untersuchung der mit den bekannten Vorrichtungen auftretenden Probleme wurde festgestellt, daß die Kontaktierungsstellen auf den Leiterplattenoberflächen teilweise stark beschädigt oder vollständig zerstört waren. In einigen Fällen wurden sogar die unter der Kupferkaschierung liegenden Harzschichten des Basismaterials freigelegt und teilweise schwarz verfärbt und beschädigt. Die Schäden waren meist nicht allein auf die Kontaktfläche selbst begrenzt, sondern erstreckten sich auf größere Bereiche, so daß auch die Oberflächenregionen der Leiterplatten beschädigt waren, in denen die Leiterbahnmuster gebildet werden sollten.

Auf Grund dieser Beobachtungen wurde vermutet, daß sich das Material an der Grenzfläche zwischen der Kontaktierungsstelle auf der Leiterplattenoberfläche und der Kontaktstelle an den Kontaktierungsorganen, beispielsweise Klammern, während des Stromdurchflusses trotz der umgebenden Behandlungsflüssigkeit stark erwärmt, so daß die erwähnten Schädigungen auftreten. Eine wirkungsvolle Ableitung der entstehenden Wärme über die herkömmlichen Kontaktierungsorgane konnte mit angemessenem Aufwand nicht erreicht werden. Da die Kontaktierungsorgane aus chemisch sehr widerstandsfähigem Material hergestellt werden müssen, wird vorzugsweise Titan eingesetzt. Dieses Material weist den Nachteil auf, daß die Wärmeleitfähigkeit schlecht ist. Der Ersatz von Titan durch das besser leitende Kupfer ist wegen dessen mangelnder chemischer Widerstandfähigkeit aber nicht möglich, da es sich beim anschließenden Entmetallisieren der Klammern auflöst.

Durch Erhöhung der Kraft, mit der die Kontaktstellen auf die Leiterplattenoberflächen aufgedrückt wurden, wurde eine Verbesserung erreicht Dadurch konnten die erwähnten Schädigungen der Kupferschicht und des Isoliermaterials vermindert werden. Da aber durch die erhöhten Kräfte wiederum Schwierigkeiten beim Öffnen und Schließen der Kontakte auftraten, stellte sich diese Lösung als nicht zufriedenstellend heraus. Übliche Kontaktkräfte liegen bei 10 bis 30 N. Außerdem kann die Kontaktkraft wegen der bestehenden Tendenz zur Verringerung der Kupferschichtdicke auf den Leiterplattenaußenseiten nicht beliebig erhöht werden. Insbesondere sehr dünne Kupferschichten, beispielsweise mit einer Dicke von 0,7 μm, sind sehr empfindlich und werden durch sehr große Kontaktkräfte beschädigt oder zerstört und dabei gegebenenfalls abgeschert. Dadurch wird der Stromfluß behindert oder sogar unterbrochen.

Eine Lösung zur Behebung der vorerwähnten Probleme wurde in der Vergrößerung der Kontaktfläche an den Kontaktstellen gesehen. Diese Lösung führt allerdings nur dann zum Ziel, wenn die verfügbare Fläche auf dem Galvanorand ausreichend groß ist. Wegen der mittlerweile bestehenden Tendenz, dessen Breite so gering wie möglich zu halten, um diesen nicht verwertbaren Flächenanteil des Leiterplattenmaterials zu minimieren, stellte sich auch diese Alternativlösung als nicht durchführbar heraus.

Im Gegensatz hierzu wird in erfindungsgemäßer Weise die Länge der Grenzlinie zwischen den Kontaktflächen der Kontaktelemente, den korrespondierenden Kontaktierungsflächen auf den plattenförmigen Gegenständen und der umgebenden Behandlungsflüssigkeit, bezogen auf die Kontaktfläche, verlängert.

Daher weisen Kontaktelemente der erfindungsgemäßen elektrochemischen Behandlungsanlage von Grenzlinien begrenzte Kontaktflächen auf, wobei die Form der Kontaktflächen derart ausgebildet ist, daß das Verhältnis V des Quadrats der Gesamtlänge L aller Grenzlinien zur Größe F aller Kontaktflächen

$$V = \frac{L^2}{F}$$

mindestens 25, vorzugsweise mindestens 30 und insbesondere mindestens 35 beträgt so das bei der Übertragung eines großen Stromes von dem auf Kontaktierungsflächen auf der elektrisch leitfähigen Oberfläche des Leiterplattenmaterials aufgedrückten Kontaktelement auf die leitfähige Oberfläche in den an die Kontaktierungsflächen angrenzenden Bereichen der leitfähigen Oberfläche keine Beschädigungen auftreten.

Die Grenzlinie begrenzt eine vorzugsweise im wesentlichen ebene Kontaktfläche. Sie markiert gleichzeitig den Übergang des Kontaktelements zur umgebenden Behandlungsflüssigkeit und zur Oberfläche des Gegenstandes, auf die das Kontaktelement aufgedrückt ist. Falls Kontaktelemente eingesetzt werden, bei denen die Kontaktflächen über abgerundete Kanten in die Seitenflächen übergehen, sind die Grenzlinien durch die Übergänge zwischen dem Kontaktelement, der Behandlungsflüssigkeit und der Oberfläche des Gegenstandes festgelegt. Auch in diesem Fall stellen die Grenzlinien die äußere Begrenzung der vorzugsweise im wesentlichen ebenen Kontaktflächen dar.

Beispielsweise kann das Kontaktelement mindestens zwei voneinander über Zwischenräume beabstandete Höcker mit jeweils einer Kontaktfläche aufweisen, wobei die Kontaktflächen vorzugsweise im wesentlichen eben (zweidimensional) sind . Die Kontaktflächen liegen im wesentlichen in einer Ebene und sind so angeordnet, daß ein elektrischer Kontakt zwischen allen Kontaktflächen und korrespondierenden Kontaktierungsflächen auf den Leiterplatten herstellbar ist. Hierzu werden die Kontaktflächen üblicherweise mit einer Kontaktkraft auf den Galvanorand der Leiterplatten aufgedrückt.

In einer anderen bevorzugten Ausführungsform kann das Kontaktelement mindestens eine Kontaktfläche aufweisen, wobei die vorzugsweise im wesentlichen ebene Kontaktfläche zur Verlängerung der Grenzlinie gegenüber der Grenzlinie bei einem herkömmlichen Kontaktelement eine Form aufweist, die gegenüber einfachen zweidimensionalen geometrischen Figuren in geeigneter Weise abgewandelt ist. Beispielsweise kann die Kontaktfläche stern-, kleeblatt- oder hantelförmig ausgebildet sein. Es sind auch andere, beispielsweise unregelmäßige Formen denkbar, die eine verlängerte Grenzlinie aufweisen. Derartige zweidimensionale Formen weisen vorzugsweise Ausbuchtungen am Umfang auf. Beispielsweise kann der Umfang auch mit Einkerbungen, ähnlich einem Sägezahn versehen werden.

Die erfindungsgemäßen Ausgestaltungen des Kontaktelements weisen den gewünschten Vorteil auf. Die Ursache hierfür ist zwar nicht bekannt. Es wird jedoch vermutet, daß durch die gewählte Anordnung eine bessere Kühlung der Kontaktstellen und eine gleichmäßigere Zuführung der großen Ströme, insbesondere zu sehr dünnen Metallschichten, ermöglicht wird. Wegen der längeren Grenzlinie fließt am Übergang zwischen den Kontaktstellen und dem Behandlungsgut eine geringere Stromdichte. Durch den Stromfluß durch die Kontaktstellen auf die Leiterplattenoberflächen wird das Material normalerweise erheblich erwarmt. Möglicherweise kann diese Erwärmung die Schädigung oder Zerstörung des Leiterplattenmaterials verursachen. Indem die Kontaktelemente mehrere mit Kontaktflächen versehene Höcker und dazwischen liegende Zwischenräume aufweisen oder die Kontaktflächen regelmäßige oder unregelmäßige geometrische Formen aufweisen, kann die Behandlungsflüssigkeit zur Kühlung der Kontaktstellen besser beitragen als im Falle der bekannten ungeteilten bzw. einfache geometrische Formen aufweisenden Kontaktelemente. Der Elektrolyt dringt hierzu in die Zwischenräume zwischen den Höckern und der Leiterplattenoberfläche bzw. zwischen die Ausbuchtungen am Umfang des Kontaktelements ein und führt die entstehende Wärme dadurch wirksamer ab. Im Gegensatz hierzu umspült die Behandlungsflüssigkeit im Falle der bekannten Kontaktelemente die monolithischen Kontaktstellen nur an der regelmäßig geformten Außenseite, so daß die Kühlwirkung in diesem Falle deutlich weniger effizient ist.

Ferner wird durch bevorzugte Ausbildung der Kontaktelemente mit vorzugsweise im wesentlichen ebenen Kontaktflächen ein innigerer elektrischer Kontakt durch bessere Auflage der Elemente auf die Leiterplattenoberfläche erreicht als bei bekannten Vorrichtungen. Dadurch kann der Übergangswiderstand und damit die Wärmeentwicklung an der Kontaktstelle erheblich reduziert werden. Außerdem wird dadurch auch eine Beschädigung von empfindlichen sehr dünnen Kupferschichten vermieden, da der lokale Druck auf die Oberflächen kleiner ist

In einer besonders bevorzugten Ausführungsform der Kontaktelemente weisen die Höcker einen im wesentlichen kreisförmigen Querschnitt parallel zu der Ebene auf, in der die Kontaktflächen liegen. Beispielsweise können die Höcker zylindrisch oder konisch mit sich zu den Kontaktflächen verjüngendem Querschnitt ausgebildet sein.

Vorzugsweise ist eine gerade Anzahl von Höckern vorgesehen. In diesem Falle können sie reihenförmig angeordnet sein. Beispielsweise können sechs, acht oder zehn derartiger Höcker in zwei Reihen angeordnet sein, wobei jeweils zwei Höcker direkt einander gegenüberliegen oder wobei die Höcker der beiden Reihen auf Lücke zueinander angeordnet sind. Selbstverständlich können auch andere Anordnungen und deren Kombinationen von derartigen mit im wesentlichen kreisförmigem Querschnitt ausgebildeten Höckern realisiert werden, beispielsweise mit einer gezahnten Außenfläche und/oder in einer Matrix von drei mal drei oder vier mal vier Kontaktstellen. Insbesondere können auch vier Höcker vorgesehen und so angeordnet sein, daß die jeweiligen Kontaktflächen an den Ecken eines Quadrats, Parallelogramms oder Trapezes angeordnet sind. Eine andere Möglichkeit besteht darin, die Höcker mit einem Querschnitt auszuführen, der von der Kreisform abweicht, beispielsweise mit einem ellipsenförmigen oder einem viereckigen Querschnitt (quadratisch oder rechteckig).

In einer anderen erfindungsgemäßen Ausführungsform ist mindestens ein Zwischenraum zwischen den Höckern vorgesehen und in Form einer Nut ausgebildet. Beispielsweise können die Höcker aus einer Kontaktstelle mit kreisförmiger Oberfläche durch Anbringen von mehreren Nuten, beispielsweise durch Einfräsen, gebildet werden. Die gebildeten Nuten unterteilen die kreisförmige Fläche in mehrere kreissegmentförmige, gegebenenfalls gezahnte Kontaktflächen, indem die Nuten insbesondere den Mittelpunkt der kreisförmigen Fläche schneiden. Werden zum Beispiel zwei Zwischenräume in Form von Nuten vorgesehen, die senkrecht zueinander angeordnet sind, wird die kreisförmige Fläche in vier gleich große kreissegmentförmige Kontaktflächen unterteilt. Eine weitere Verbesserung ist erreichbar, wenn die Kontaktelemente zur Erhöhung des Stoffaustausches und der Kühlung stark mit Behandlungsflüssigkeit angeströmt werden. Die vorbeschriebenen Ausführungsformen verbessern die Wirkungsweise der Anströmung erheblich.

Das Kontaktelement wird vorzugsweise aus einem elektrochemisch widerstandsfähigen Metall, beispielsweise aus Titan, Niob, Tantal oder Legierungen dieser Metalle untereinander oder mit anderen Metallen hergestellt. Indem diese Materialien eingesetzt werden, kann grundsätzlich auf einen weitergehenden Schutz der Kontaktierungsorgane gegen einen chemischen Angriff durch die Behandlungsflüssigkeit verzichtet werden.

Es kann jedoch vorteilhaft sein, die Kontaktierungselemente fast vollständig mit einem Isolierwerkstoff, beispielsweise einem Schutzlack, zu ummanteln, um deren Beschichtung mit Metall während des Betriebes zu vermeiden. Lediglich die Kontaktflächen müssen frei von dem Isolierwerkstoff bleiben, um eine einwandfreie Kontaktierung der Leiterplatten gewährleisten zu können.

Da die Kontaktstellen nach dem Durchlauf durch eine Metallisierungskammer meist wieder entmetallisiert werden, wird auf den übrigen Oberflächen der Organe abgeschiedenes Metall während der Entmetallisierung ebenfalls wieder entfernt. Daher kann auf Schutzummantelungen mit dem Isolierwerkstoff grundsätzlich verzichtet werden.

Werden die Kontaktelemente nicht aus den oben genannten, elektrisch relativ schlecht leitenden Metallen hergestellt, sondern beispielsweise aus Kupfer, ist ein Schutz gegen Korrosion erforderlich. Da Kupfer gegen einen chemischen Angriff durch die Behandlungsflüssigkeiten in vielen Fällen nicht ausreichend beständig ist, werden die Kontaktflächen mit einer elektrisch leitfähigen, chemisch widerstandsfähigen Beschichtung überzogen. Derartige Beschichtungen können vorzugsweise aus Gold, Platin, Iridium, Ruthenium, Rhodium, Legierungen dieser Metalle oder Mischoxiden bestehen.

Zur nachfolgenden Erläuterung der Erfindung wird auf die Figuren 1 bis 6 verwiesen. Es zeigen:

Figur 1: einen Ausschnitt aus einer Leiterplattengalvanisieranlage;
Figur 2: eine erste Ausführungsform eines Kontaktelements;
Figur 3: eine zweite Ausführungsform eines Kontaktelements;
Figur 4: eine dritte Ausführungsform eines Kontaktelements;
Figur 5: verschiedene Kontaktflächen weiterer Ausführungsformen;
Figur 6: eine Kontaktierungsklammer.

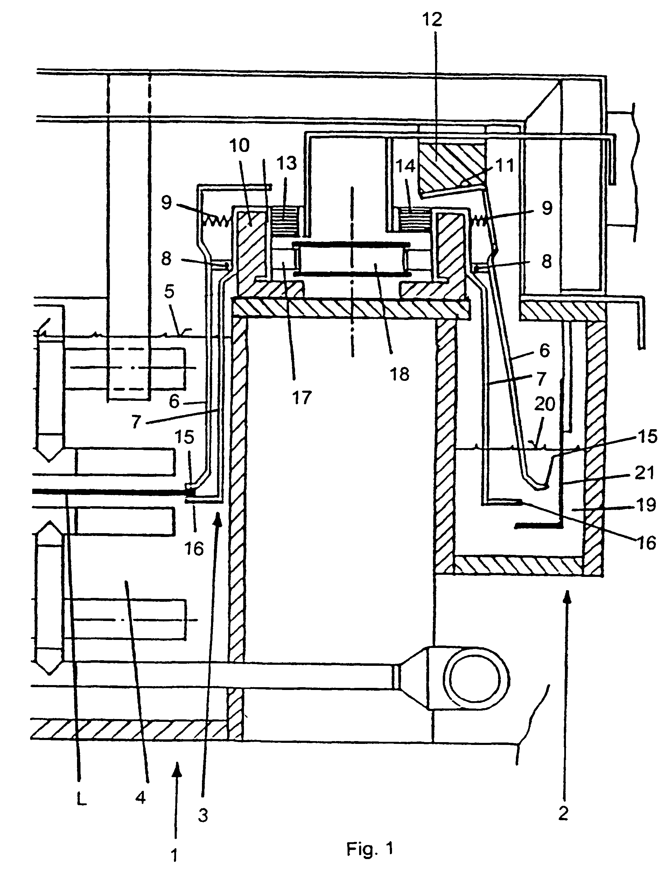

In **Fig. 1** ist ein Schnitt durch einen Teil einer Leiterplattengalvanisieranlage mit einem Galvanisierabteil **1** und einem Entmetallisierabteil **2** dargestellt. Soweit sich der Aufbau der Anlage nicht auf die Kontaktelemente 15,16 bezieht, ist deren Aufbau grundsätzlich bekannt.

Die Leiterplatten **L** werden mittels geeigneter Führungsorgane (nicht dargestellt) in einer Transportebene durch das Galvanisierabteil **1** hindurchgeführt. Sie sind hierbei horizontal ausgerichtet und werden in horizontaler Richtung transportiert (senkrecht zur Figurenebene). Als Führungsorgane werden üblicherweise Rollen eingesetzt.

Zum Vortrieb der Leiterplatten **L** werden die auch zur elektrischen Kontaktierung der Leiterplatten **L** dienenden Kontaktierungsorgane **3** eingesetzt, die hier als Klammern ausgebildet sind. Derartige Klammern **3** können auch am gegenüberliegenden Rand der Leiterplatten **L** vorgesehen sein, so daß die Platten beidseitig gegriffen und vorgetrieben werden (außerhalb des Figurenausschnitts).

Die Klammern **3** bestehen aus Titan, so daß sie gegenüber der ätzenden Behandlungsflüssigkeit **4** beständig sind. Die Leiterplatten **L** werden innerhalb der Galvanisierflüssigkeit **4** (Flüssigkeitsspiegel **5**) geführt, so daß sie vollständig von Flüssigkeit umgeben sind. Üblicherweise werden auf beiden Seiten mit einer Kupferbasisschicht versehene Leiterplatten bearbeitet, so daß der Strom an beide Seiten herangeführt werden muß. Im Entmetallisierabteil **2** befindet sich eine für die Entmetallisierung der Klammern **3** geeignete Entmetallisierflüssigkeit **19** mit dem oberen Flüssigkeitsspiegel **20** sowie eine Gegenelektrode **21**.

Die Kontaktierungsklammern **3** werden von einer endlosen Kette oder einem endlosen Zahnriemen **17,** beispielsweise aus Kunststoff, angetrieben und sind in engem Abstand, beispielsweise im Abstand von 6 cm, hintereinander aufgereiht. Der Zahnriemen wird über Rollen **18** geführt. Die Klammern **3** werden über einen inneren Klammerbügel **7** an einer Führungsschiene **10** geführt, indem dieser Bügel die Schiene umgreift. Dadurch durchlaufen die Klammern **3** nacheinander das Galvanisierabteil **1** und das Entmetallisierabteil **2**.

Die Klammern **3** bestehen aus zwei Klammerbügeln **6,7**, die im Drehpunkt **8** miteinander verbunden sind, so daß der äußere Bügel **6** gegen den inneren Bügel **7** gegen eine Kraft verschwenkt werden kann, die von der Druckfeder **9** aufgebracht wird. Die Druckfeder **9** stützt sich zwischen beiden Bügeln **6** und **7** oberhalb des Drehpunktes **8** ab. In Ruhestellung drückt die Druckfeder **9** die Bügel **6,7** gegeneinander, so daß die Klammer **3** geschlossen ist. Dies ist der Fall, wenn die Klammer **3** im Galvanisierabteil **1** geführt wird. Beim Auslaufen der Klammer **3** aus dem Galvanisierabteil **1** läuft der äußere Bügel **6** gegen die Anlauffläche **11** einer Anlaufschiene **12** an, über die die Klammer zwangsweise entgegen der Federkraft geöffnet wird. Durch das Öffnen der Klammer **3** wird die Leiterplatte **L** wieder freigegeben und kann aus der Anlage ausfahren. Im Rücklauf läuft der Bügel **6** weiterhin gegen die Anlauffläche **11,** so daß die Klammer **3** dabei geöffnet bleibt.

Die Klammern **3** werden über Schleifkontakte **13,14** mit Strom versorgt. Hierzu gleitet der innere Bügel **7** an den Schleifkontakten **13,14** entlang. Im Galvanisierabteil **1** ist der Kontakt **13** kathodisch gepolt und im Entmetallisierabteil **2** der Schleifkontakt **14** anodisch.

Beim Einlauf der Klammern **3** in das Galvanisierabteil **1** ergreifen diese die ebenfalls einlaufenden Leiterplatten **L** im Bereich des Galvanorandes. Indem eine Kraft von 10 bis 30 N durch die Feder **9** auf die Kontaktelemente **15,16** ausgeübt wird, wird eine sehr feste mechanische Verbindung zwischen der Klammer **3** und der Leiterplatte **L** erreicht. Beim Auslaufen der Klammern **3** aus dem Entmetallisierabteil **2** läuft der äußere Bügel **6** von der Anlauffläche **11** wieder ab, so daß die Klammer **3** schließen kann. Das Ende der Anlaufschiene **12** mit der Anlauffläche **11** ist so positioniert, daß die sich schließende Klammer **3** eine an dieser Stelle in die Anlage einlaufende Leiterplatte **L** greifen kann. Je nach Größe der Leiterplatten **L** und dem Abstand der Klammern **3** voneinander können vier bis acht Klammern eine Leiterplatte gleichzeitig ergreifen.

Während die Leiterplatten **L** von den Klammern **3** gegriffen sind, werden die Platten kathodisch polarisiert und über die Schleifkontakte **13** und die Klammern **3** mit Strom versorgt. Nach dem Ausfahren der geöffneten Klammern **3** aus dem Galvanisierabteil **1** gelangen diese in das Entmetallisierabteil **2**. Dort werden sie über den Kontakte **14** und die Klammern **3** anodisch gepolt und mit Strom versorgt. Während der Galvanisierphase im Galvanisierabteil **1** aufgewachsenes Metall auf den Klammern **3** kann im Entmetallisierabteil **2** durch die anodische Polarisation wieder abgelöst werden.

Zur Übertragung großer Ströme sind an den Spitzen der Kontaktbügel **6,7** obere Kontaktelemente **15** und untere Kontaktelemente **16** angeordnet. Diese Kontaktelemente **15,16** werden fest auf korrespondierende Stellen auf der Oberfläche der Leiterplatte L gedrückt.

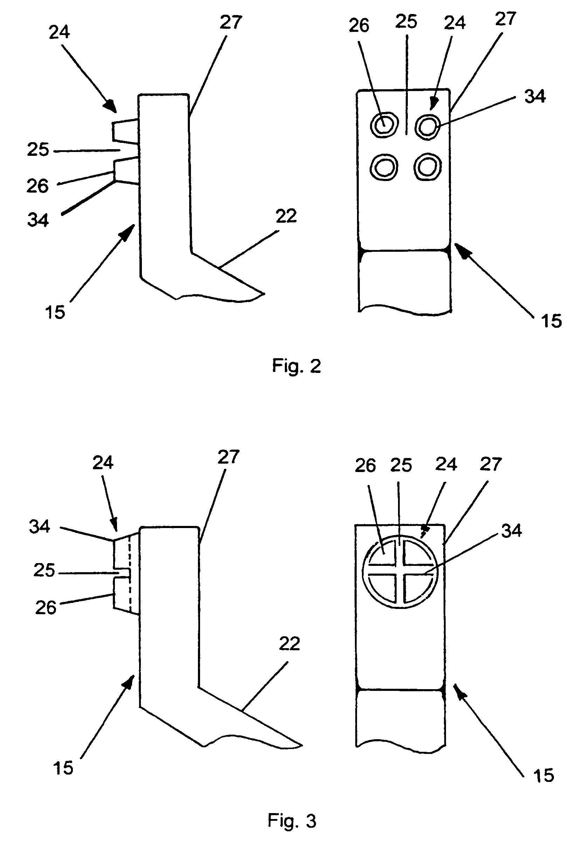

Eine erste Ausführungsform eines Kontaktelements **15** ist in **Fig. 2** dargestellt. Das Kontaktelement **15** ist am Schaft **22** des äußeren Klammerbügels **6** befestigt. In gleicher Weise ist das (nicht dargestellte) Kontaktelement **16** an dem Schaft **23** des inneren Klammerbügels **7** befestigt. Die Kontaktelemente **15,16** bestehen im wesentlichen aus einem Kontaktfuß **27** und den daran befestigten Höckern **24** mit dazwischen angeordneten Zwischenräumen **25**. In dieser Ausführungsform sind vier Höcker **24** vorgesehen, wobei die Höcker an den Ecken eines Quadrates angeordnet sind. Die Kontakthöcker **24** weisen einseitig Kontaktflächen **26** auf, die von der Grenzlinie **34** begrenzt sind. Beim Schließen der Klammer **3** werden die Kontaktflächen **26** sehr fest auf korrespondierende Kontaktierungsflächen auf den Leiterplattenoberflächen aufgedrückt. Durch die Planarität der Kontaktflächen **26** wird ein inniger elektrischer Kontakt mit sehr geringem Kontaktwiderstand zwischen den Kontaktflächen der Höcker **24** und den Leiterplattenoberflächen erreicht. Zum Erzeugen eines guten elektrischen Kontaktes bestehen die Höcker **24** aus Kupfer. Um eine ausreichende Korrosionsbeständigkeit der Höcker **24** gegen die Behandlungsflüssigkeit zu erreichen, ist deren Kupferoberfläche mit einer ausreichend dicken Goldschicht überzogen. Alternativ können auch andere Edelmetalle oder elektrisch leitfähige Mischoxide als Schutzschicht verwendet werden.

Indem zwischen den Höckern **24** Zwischenräume **25** vorgesehen sind, können die Höcker **24** auch dann von Behandlungsflüssigkeit umströmt werden, wenn die Kontakte **15,16** fest auf den Leiterplatten **L** aufliegen. Dadurch wird wahrscheinlich eine wirksame Kühlung der Kontakte **15,16** erreicht, so daß die Leiterplattenoberflächen durch Überhitzung nicht beschädigt werden.

Eine zweite Ausführungsform der Kontakte ist in **Fig. 3** dargestellt. Auch in diesem Fall bestehen die Kontaktelemente **15** (**16** nicht dargestellt) aus dem Kontaktfuß **27** und den an dem Kontaktfuß **27** angeordneten Höckern **24**. Die Höcker **24** werden in diesem Falle aus einer kreisförmigen Oberfläche durch Einfräsen von Nuten **25**, die die Zwischenräume zwischen den Höckern **24** bilden, erzeugt. In diesem Fall sind zwei Nuten **25** vorhanden, die rechtwinklig zueinander gebildet sind und die die ursprünglich kreisförmige Fläche in vier symmetrisch zueinander angeordnete kreissegmentförmige Höcker **24** aufteilen. Die einzelnen Höcker **24** weisen auch in diesem Fall einseitig Kontaktflächen **26** auf, die von der Grenzlinie **34** begrenzt sind.

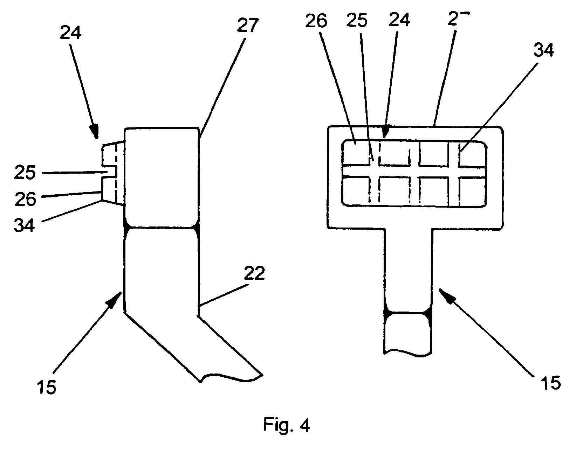

Eine dritte Ausführungsform für die Kontakte ist in **Fig. 4** angegeben. In diesem Fall weist der Kontaktfuß **27** der Kontaktelemente **15** (**16** nicht dargestellt) eine längliche Form auf. Die einzelnen Höcker **24** sind in einer reihenförmigen Matrix angeordnet und durch Einfräsungen erzeugt, die gleichzeitig die Zwischenräume (Nuten) **25** bilden. Die Höcker **24** weisen wiederum einseitig ebene Kontaktflächen **26** auf, die von der Grenzlinie **34** begrenzt sind.

Durch die längliche Form der Höckeranordnung kann eine große Auflagefläche auf einem sehr schmalen Galvanorand gebildet werden, wobei gleichzeitig eine ausreichend große Kontaktfläche F zur Verfügung steht. Dadurch kann die Breite des nicht verwertbaren Galvanorandes weiter reduziert werden.

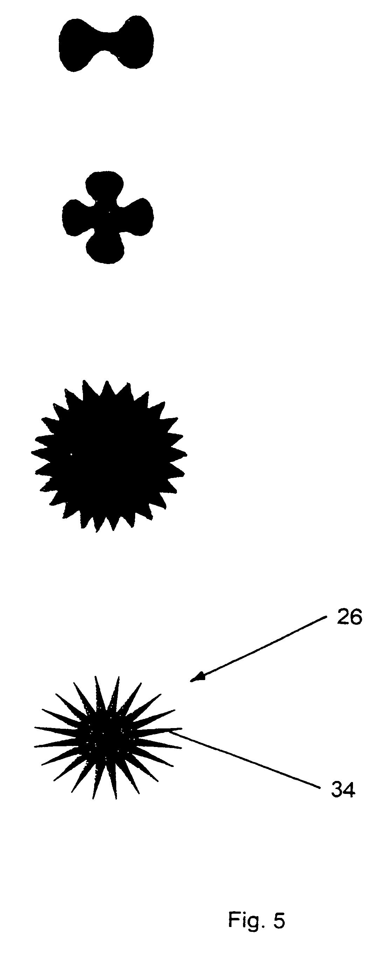

In **Fig. 5** sind weitere Ausführungsformen für geometrische Formen von Kontaktflächen **26** dargestellt. Jede Kontaktfläche **26** ist von einer Grenzlinie **34** begrenzt. Es können Steme, kleeblattförmige oder hantelförmige Formen verwendet werden. Außerdem können auch Kontaktelemente **26** mit einem oder mehreren sägezahnartig ausgebildeten Kreisen als Kontaktflächen **26** eingesetzt werden.

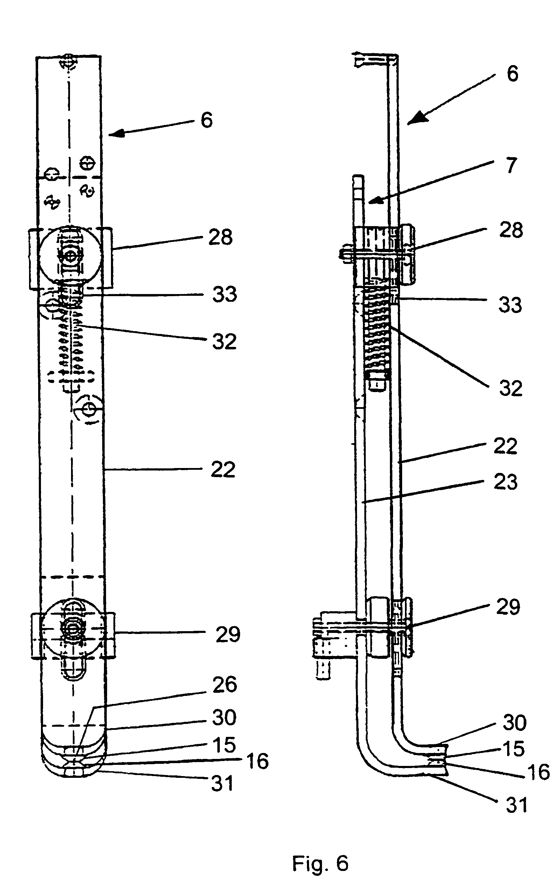

In **Fig. 6** ist eine alternative Ausführungsform einer Kontaktierungsklammer **3** dargestellt, an deren beiden Bügeln **6,7** die Kontaktelemente **15,16** befestigt sind. In diesem Fall sind zwei parallel zueinander angeordnete Bügel **6,7** vorgesehen. Der äußere Bügel **6** ist mit dem inneren Bügel **7** derart verbunden, daß beide gegeneinander parallel zu ihrer Längsachse verschiebbar sind. Der innere Bügel **7** ist am oberen Ende derart ausgebildet, daß er an einer Führungsschiene geführt werden kann, beispielsweise so wie in **Fig. 1** dargestellt (Führungsschiene **10**). Der Schaft **22** des äußeren Bügels **6** ist in diesem Fall in den am Schaft **23** des inneren Bügels **7** befestigten Gleitlagern in Gleitlagerkörpern **28,29** über ein Langloch **33** geführt, so daß er parallel zur Schaft-Längsachse beweglich ist. Die unteren Enden beider Bügel sind in unterschiedlicher Höhe um jeweils etwa 90° in dieselbe Richtung abgewinkelt. An den Enden der abgewinkelten Arme **30,31** sind die Kontaktelemente **15,16** angeordnet.

Die beiden Arme **30,31** werden durch die Druckfeder **32** gegeneinander gepreßt. Die Feder **32** stützt sich an dem feststehenden inneren Bügel **7** über den oberen Gleitlagerkörper **28** und an einem am äußeren Bügel **6** befestigten Vorsprung (nicht dargestellt) ab.

Durch die Paralleiführung des äußeren Bügels **6** gegen den inneren Bügel **7** wird erreicht, daß die Kontaktflächen **26** der Kontaktelemente **15** und **16** genau parallel aufeinander auftreffen, so daß ein optimaler Kontakt der Kontaktflächen **26** zu den Oberflächen der Leiterplatte **L** geschaffen werden kann, die ebenfalls parallel zu den Kontaktflächen **26** ausgerichtet ist.

Bezugszeichenliste:

| | |
|---|---|
| **1** | Galvanisierabteil |
| **2** | Entmetallisierabteil |
| **3** | Kontaktierungsklammer |
| **4** | Behandlungsflüssigkeit |
| **5** | Flüssigkeitsspiegel der Behandlungsflüssigkeit **4** |
| **6** | äußerer Klammerbügel |
| **7** | innerer Klammerbügel |
| **8** | Drehpunkt |
| **9** | Druckfeder |
| **10** | Führungsschiene |
| **11** | Anlauffläche |
| **12** | Anlaufschiene |
| **13** | Schleifkontakt |
| **14** | Schleifkontakt |
| **15** | oberes Kontaktelement |
| **16** | unteres Kontaktelement |
| **17** | Zahnriemen |
| **18** | Rollen |
| **19** | Entmetallisierflüssigkeit |
| **20** | Flüssigkeitsspiegel der Entmetallisierflüssigkeit **19** |
| **21** | Gegenelektrode |
| **22** | Schaft des äußeren Bügels **6** der Kontaktierungsklammer **3** |
| **23** | Schaft des inneren Bügels **7** der Kontaktierungsklammer **3** |
| **24** | Höcker |
| **25** | Zwischenräume zwischen den Höckern **24** |
| **26** | Kontaktfläche auf dem Höcker **24** |
| **27** | Kontaktfuß |
| **28** | Gleitlagerkörper |
| **29** | Gleitlagerkörper |
| **30** | abgewinkelter Arm des äußeren Bügels **6** der Kontaktierungsklammer **3** |
| **31** | abgewinkelter Arm des inneren Bügels **7** der Kontaktierungsklammer **3** |
| **32** | Druckfeder |
| **33** | Langloch |
| **34** | Grenzlinie |
| **L** | Leiterplatte |

**Patentansprüche**

1. Elektrochemische Behandlungsanlage für elektrolytisch zu behandelndes Leiterplattenmaterial, die mindestens ein Kontaktierungsorgan für die Stromzuführung zu dem Leiterplattenmaterial aufweist, das jeweils

    a) mindestens einen Schaft (22,23) und
    b) mindestens ein Kontaktelement (15,16) an einem Ende des Schaftes (22,23), wobei das Kontaktelement (15,16) eine von einer Grenzlinie (34) begrenzte Kontaktfläche (26) aufweist,
    c) wobei der Schaft (22,23) mit dem Kontaktelement (15,16) über eine Rückstellkraft bewegbar ist, so dass das Kontaktelement (15,16) auf die Oberfläche des Leiterplattenmaterials (L) gedrückt werden kann,

    umfasst, **dadurch gekennzeichnet, dass** die Form der Kontaktfläche (26) derart ausgebildet ist, dass das Verhältnis V des Quadrats der Länge L der Grenzlinie (34) zur Größe F der Kontaktfläche (26)

    $$V = \frac{L^2}{F}$$

    mindestens 25 beträgt, so dass bei der Übertragung eines großen Stromes von dem auf Kontaktierungsflächen auf der elektrisch leitfähigen Oberfläche des Leiterplattenmaterials (L) aufgedrückten Kontaktelement (15,16) auf die leitfähige Oberfläche in den an die Kontaktierungsflächen angrenzenden Bereichen der leitfähigen Oberfläche keine Beschädigungen auftreten.

2. Elektrochemische Behandlungsanlage nach Anspruch 1, **dadurch gekennzeichnet, dass** die Kontaktfläche (26) im Wesentlichen eben ist.

3. Elektrochemische Behandlungsanlage nach einem der vorstehenden Ansprüche, **dadurch gekennzeichnet, dass** das Kontaktelement (15,16) im Wesentlichen aus Titan, Niob, Tantal oder Legierungen dieser Metalle untereinander oder mit anderen Metallen besteht.

4. Elektrochemische Behandlungsanlage nach einem der vorstehenden Ansprüche, **dadurch gekennzeichnet, dass** die Kontaktflächen (26) im wesentlichen aus Kupfer bestehen.

5. Elektrochemische Behandlungsanlage nach einem der vorstehenden Ansprüche, **dadurch gekennzeichnet, dass** die Kontaktflächen (26) mit einer elektrisch leitfähigen, chemisch widerstandsfähigen Beschichtung aus Gold, Platin, Iridium, Ruthenium, Rhodium, Legierungen dieser Metalle oder Mischoxiden überzogen sind.

6. Verfahren zur Zuführung von Strom zu elektrolytisch zu behandelndem Leiterplattenmaterial, bei dem
ein stromführendes, eine von einer Grenzlinie (34) begrenzte Kontaktfläche (26) aufweisendes Kontaktelement (15,16) eines Kontaktierungsorgans auf die Oberfläche des Leiterplattenmaterials (L) aufgedrückt und **dadurch** ein Stromfluss zwischen dem Kontaktelement (15,16) und dem Leiterplattenmaterial (L) erzeugt wird,
**dadurch gekennzeichnet, dass** die Form der Kontaktfläche (26) derart ausgebildet wird, dass das Verhältnis V des Quadrats der Länge L der Grenzlinie (34) zur Größe F der Kontaktfläche (26)

$$V = \frac{L^2}{F}$$

mindestens 25 beträgt, so dass bei der Übertragung eines großen Stromes von dem auf Kontaktierungsflächen auf der elektrisch leitfähigen Oberfläche des Leiterplattenmaterials (L) aufgedrückten Kontaktelement (15,16) auf die leitfähige Oberfläche in den an die Kontaktierungsflächen angrenzenden Bereichen der leitfähigen Oberfläche keine Beschädigungen auftreten.

**Claims**

1. Electrochemical treatment plant for printed circuit board material to be treated electrolytically, said plant having at least one contacting member for the current supply to the printed circuit board material, which member comprises respectively

   a) at least one shaft (22, 23) and

   b) at least one contact element (15, 16) on one end of the shaft (22, 23), the contact element (15, 16) having one contact face (26) which is delimited by a boundary line (34),

c) the shaft (22, 23) with the contact element (15, 16) being moveable via a restoring force so that the contact element (15, 16) can be pressed onto the surface of the printed circuit board material (L),

**characterised in that** the form of the contact face (26) is configured in such a manner that the relation V of the square of the length L of the boundary line (34) to the size F of the contact face (26)

$$V = \frac{L^2}{F}$$

is at least 25 so that, upon transmission of a large current from the contact element (15, 16), which is pressed on contacting areas on the electrically conductive surface of the printed circuit board material (L), to the conductive surface in the regions of the conductive surface which abut against the contacting areas, no damage occurs.

2. Electrochemical treatment plant according to claim 1, **characterised in that** the contact face (26) is substantially flat.

3. Electrochemical treatmerrt plant according to one of the preceding claims, **characterised in that** the contact element (15, 16) is formed substantially from titanium, niobium, tantalum or alloys of these metals with each other or with other metals.

4. Electrochemical treatment plant according to one of the preceding claims, **characterised in that** the contact faces (26) are formed substantially from copper.

5. Electrochemical treatment plant according to one of the preceding claims, **characterised in that** the contact faces (26) are covered with an electrically conductive, chemically resistive coating made of gold, platinum, iridium, ruthenium, rhodium, alloys of these metals or mixed oxides.

6. Method of supplying current to printed circuit board material to be treated electrolytically, in which
a current-conducting contact element (15, 16) of a contacting member, which contact element has one contact face (26) delimited by a boundary line (34), is pressed onto the surface of the printed circuit board material (L) and consequently a flow of current is produced between the contact element (15, 16) and the printed circuit board material (L),
**characterised in that** the form of the contact face (26) is configured in such a manner that the relation V of the square of the length L of the boundary line (34) to the size F of the contact face (26)

$$V = \frac{L^2}{F}$$

is at least 25, so that, upon transmission of a large current from the contact element (15, 16), which is pressed on contacting areas on the electrically conductive surface of the printed circuit board material (L), to the conductive surface in the regions of the conductive surface which abut against the contacting areas, no damage occurs.

## Revendications

1. Appareil de traitement électrochimique pour circuit imprimé à traiter électrolytiquement, qui comporte au moins un organe de contact pour fournir le courant au circuit imprimé, qui comprend respectivement

a) au moins une tige (22, 23) et
b) au moins un élément de contact (15, 16) à l'une des extrémités de la tige (22, 23), l'élément de contact (15, 16) comportant au moins une surface de contact (26) délimitée par une bordure (34),
c) la tige (22, 23) étant déplaçable avec l'élément de contact (15, 16) au moyen d'une force de rappel, de sorte que l'élément de contact (15, 16) puisse être pressé sur la surface du circuit imprimé (L),

**caractérisé en ce que** la forme de la surface de contact (26) est conçue de telle façon que le quotient V du carré de la longueur L de la bordure (34) sur la grandeur F de la surface de contact (26)

$$V = \frac{L^2}{F}$$

s'élève au moins à 25, de sorte qu'aucune dégradation ne se produise sur la surface conductrice dans les régions limitrophes aux surfaces de contact de la surface conductrice lors de la transmission d'un courant important de l'élément de contact (15, 16) pressé sur les surfaces de contact sur la surface conductrice du circuit imprimé (L).

2. Appareil de traitement électrochimique selon la revendication 1, **caractérisé en ce que** la surface de contact (26) est sensiblement plate dans l'ensemble.

3. Appareil de traitement électrochimique selon l'une quelconque des revendications précédentes, **caractérisé en ce que** l'élément de contact (15, 16) se compose sensiblement de titane, de niobium, de tantale ou d'alliages de ces métaux entre eux ou avec d'autres métaux.

4. Appareil de traitement électrochimique selon l'une quelconque des revendications précédentes, **caractérisé en ce que** les surfaces de contact (26) se composent dans l'ensemble sensiblement de cuivre.

5. Appareil de traitement électrochimique selon l'une quelconque des revendications précédentes, **caractérisé en ce que** les surfaces de contact (26) sont recouvertes avec un revêtement électriquement conducteur chimiquement résistant d'or, de platine, d'iridium, de ruthénium, de rhodium, d'alliages de ces métaux ou d'oxydes de mélanges.

6. Procédé pour fournir du courant au circuit imprimé à traiter électrolytiquement, dans lequel un élément de contact (15, 16) d'un organe de contact, fournissant du courant et comportant une surface de contact (26) délimitée par une bordure (34), est pressé sur la surface du circuit imprimé (L) et ainsi un courant est produit entre l'élément de contact (15, 16) et le circuit imprimé (L), **caractérisé en ce que** la forme de la surface de contact (26) est formée de telle façon que le quotient V du carré de la longueur L de la bordure (34) sur la grandeur F de la surface de contact (26)

$$V = \frac{L^2}{F}$$

s'élève au moins à 25, de sorte qu'aucune dégradation ne se produise sur la surface conductrice dans les régions limitrophes aux surfaces de contact de la surface conductrice lors de la transmission d'un courant important de l'élément de contact (15, 16) pressé sur la surface de contact sur la surface conductrice du circuit imprimé (L).

Fig. 1

Fig. 2

Fig. 3

Fig. 4

26

34

Fig. 5

Fig. 6